# EUROPEAN PATENT APPLICATION

(11) **EP 4 624 952 A1**
(43) Date of publication of application: **01.10.2025**
(21) Application number: 25166207.8
(22) Date of filing: 26.03.2025
(51) Int. Cl.: G01R 31/36, G01R 31/389

(54) **CHARACTERISTIC MEASURING JIG OF BATTERY CELL FOR RECHARGEABLE BATTERY AND CHARACTERISTIC MEASURING APPARATUS INCLUDING THE SAME**

(30) Priority: 28.03.2024 KR 20240042664
(71) Applicant: SAMSUNG SDI CO., LTD., Yongin-si, Gyeonggi-do 17084 (KR)
(72) Inventor: SHIN, Eui-Chol, 17084 Gyeonggi-do (KR); KA, Bokhyun, 17084 Gyeonggi-do (KR); HWANG, Taehyun, 17084 Gyeonggi-do (KR); RYU, Ji-Hyun, 17084 Gyeonggi-do (KR)
(74) Representative: Michalski Hüttermann & Partner Patentanwälte mbB

(57) **Abstract**

A characteristic measuring jig includes a support to support a battery cell, an impedance measuring part including first and second positive electrode contact parts, first and second negative electrode contact parts, a first terminal for current connected to the first positive electrode contact part, a first terminal for voltage connected to the second positive electrode contact part, a second terminal for current connected to the first negative electrode contact part, and a second terminal for voltage connected to the second negative electrode contact part that is detachable to a terminal side of the battery cell, and an elevating part fixed to the support, connected to the impedance measuring part, and configured to elevate the impedance measuring part. At least one of the first terminal for current and the second terminal for current is opposite to at least one of the first terminal for voltage and the second terminal for voltage.

## Description

### BACKGROUND

### 1. Field

The present disclosure relates to a characteristic measuring apparatus of a battery cell, and to an apparatus for measuring the impedance of a battery cell.

### 2. Description of the Related Art

Unlike primary batteries, rechargeable batteries are batteries that may be repeatedly charge and discharge. Small-capacity rechargeable batteries are used in small, portable electronic devices such as mobile phones, laptop computers, and camcorders. High-capacity and high-density rechargeable batteries are used as power sources for driving motors in hybrid and electric vehicles or for energy storage.

The rechargeable batteries may be provided to consumers after undergoing characteristic tests on the stability and performance characteristics of battery cells. One of the characteristic tests includes an impedance test of the battery cells of the rechargeable battery.

When measuring the impedance of battery cells, it is important to ensure that the impedance to be measured is not distorted due to an increase in inductance due to the structure or arrangement of measurement equipment components (e.g., current lines, voltage lines).

The above information disclosed in this Background section is only for enhancement of understanding of the background of the described technology and therefore it may contain information that does not form the prior art that is already known in this country to a person of ordinary skill in the art.

### SUMMARY

The present disclosure relates to various embodiments of a characteristic measuring apparatus configured to measure one or more characteristics of a battery cell and configured to minimize or at least reduce the influence of inductance when measuring the impedance of a battery cell.

Effects that may be obtained from the present disclosure will not be limited to only the above described effects. In addition, other effects which are not described herein will become apparent to those skilled in the art from the following description.

A characteristic measuring jig of a battery cell for a rechargeable battery according to embodiments of the present disclosure includes a support provided with a battery cell including a terminal side including a positive electrode terminal and a negative electrode terminal, an impedance measuring part detachable to a terminal side of the battery cell, and an elevating part fixed to the support, connected to the impedance measuring part, and configured to elevate the impedance measuring part with respect to the terminal side of the battery cell.

The impedance measuring part includes a first positive electrode contact part and a second positive electrode contact part configured to contact the positive electrode terminal, a first negative electrode contact part and a second negative electrode contact part configured to contact the negative electrode terminal, a first terminal for current connected to the first positive electrode contact part and configured to apply current to the battery cell, a first terminal for voltage connected to the second positive electrode contact part and configured to measure the voltage of the battery cell, a second terminal for current connected to the first negative electrode contact part and configured to apply current to the battery cell, and a second terminal for voltage connected to the second negative electrode contact part and configured to measure voltage of the battery cell.

At least one of the first terminal for current and the second terminal for current is substantially opposite to at least one of the first terminal for voltage and the second terminal for voltage.

The impedance measuring part may include a first body to which the first and second positive electrode contact parts, the first terminal for current, and the first terminal for voltage are coupled, and a second body to which the first and second negative electrode contact parts, the second terminal for current, and the second terminal for voltage are coupled, spaced apart from the first body and adjacent to the first body.

The first terminal for current and the first terminal for voltage may be non-overlapping on a same line in the first body.

The second terminal for current and the second terminal for voltage may be non-overlapping on a same line in the second body.

The area of the first positive electrode contact part may be equal to or larger than the area of the second positive electrode contact part.

The area of the first negative electrode contact part may be equal to or greater than the area of the second negative electrode contact part.

The impedance measuring part may include a single body to which the first and second positive electrode contact parts, the first terminal for current, the first terminal for voltage, the first and second negative electrode contact parts, the second terminal for current and the second terminal for voltage are coupled.

The first terminal for current and the first terminal for voltage may be non-overlapping on a same line in the single body.

The second terminal for current and the second terminal for voltage may be disposed between the first terminal for current and the first terminal for voltage. The angle between the second terminal for current and the second terminal for voltage may be an acute angle.

The area of the first positive electrode contact part and the area of the first negative electrode contact part may be equal to or greater than the area of the second positive electrode contact part and the area of the second negative electrode contact part.

A fixing frame for fixing the battery cell may be on the support.

The support may include a bottom plate and a vertical plate extending from one side of the bottom plate, and the fixing frame may be on the bottom plate.

The battery cell fixed to the fixing frame may have a prismatic shape.

A supporting frame for supporting the battery cell may be on the support.

The support may include a bottom plate and a vertical plate extending from one side of the bottom plate, and the supporting frame may be on the bottom plate.

The battery cell supported on the fixing frame may have a cylindrical shape.

A characteristic measuring apparatus configured to measure one or more characteristics of a battery cell for a rechargeable battery according to another embodiment of the present disclosure includes a housing in which the above-described measuring jig is accommodated. The housing includes a chamber having a current wire configured to apply current to the first and second terminals for current, and a voltage wire configured to sense voltage of the battery cell from the first and second terminals for voltage.

According to the embodiments of the present disclosure, the inductance may be reduced when measuring the impedance of a battery cell as the terminals for current and the voltage of the measuring jig are arranged to be non-overlapping.

Accordingly, it is possible to reduce the distortion of the impedance of the battery cell to be measured by reducing the resistance that interferes with the flow of current.

### BRIEF DESCRIPTION OF THE DRAWINGS

The accompanying drawings illustrate embodiments of the present disclosure and, together with the foregoing disclosure, serve to provide further understanding of the technical idea of the present disclosure. However, the present disclosure is not to be construed as being limited to the drawings.
FIG. 1 is a perspective view schematically illustrating a characteristic measuring apparatus of a battery cell for a rechargeable battery according to embodiments.
FIG. 2 is a perspective view schematically illustrating a measuring jig according to the first embodiment.
FIG. 3 is a perspective view illustrating a battery cell according to the first embodiment.
FIGS. 4A to 4D are diagrams to describe an impedance measuring part according to the first embodiment.
FIGS. 5A and 5B are graphs shown to describe the effect of the measuring jig according to the first embodiment.
FIG. 6 is a perspective view schematically illustrating a measuring jig according to the second embodiment.
FIG. 7 is a perspective view illustrating a battery cell according to the second embodiment.
FIGS. 8A to 8D are diagrams to describe an impedance measuring part according to the second embodiment.
FIGS. 9A and 9B are graphs shown to describe the effect of the measuring jig according to the second embodiment and a comparative related art example.

### DETAILED DESCRIPTION

Hereinafter, aspects of some embodiments of the present disclosure will be described in detail with reference to the accompanying drawings. Prior to making the description, the terms or words used in the specification and claims of the present disclosure are not interpreted using typical or dictionary limited meanings, and are constructed as meanings and concepts conforming to the technical idea of the present disclosure based on the principle that the inventors can appropriately define the concepts of the terms to explain the present disclosure in the best manner. Accordingly, it is to be understood that the detailed description, which will be disclosed along with the accompanying drawings, is intended to describe the embodiments of the present disclosure and is not intended to represent all technical ideas of the present disclosure. Therefore, it should be understood that various equivalents and modifications can exist which can replace the embodiments described at the time of filling the application.

It will be further understood that the terms "comprise or include" and/or "comprising or including," when used in this specification, specify the presence of stated features, numbers, steps, operations, elements, and/or components, but do not preclude the presence or addition of one or more other features, numbers, steps, operations, elements, components, and/or groups thereof.

In addition, for ease of understanding of the present disclosure, the accompanying drawings are not drawn to real scale, but the dimensions of some components may be exaggerated. In addition, the same reference numbers may be assigned to the same components in different embodiments.

Stating that two objects of comparison are 'the same' means that they are 'substantially the same'. Therefore, substantially identical may include a deviation that is considered low in the art, for example, a deviation of less than 5 %. Additionally, uniformity of a parameter in a certain region may mean uniformity from an average perspective.

Although terms of "first," "second," and the like are used to explain various constituent elements, the constituent elements are not limited to such terms. These terms are only used to distinguish one constituent element from another constituent element. Unless explicitly described to the contrary, the second constituent element may be referred to as the first constituent element.

Throughout the specification, unless otherwise stated, each component may be singular or plural.

It will also be understood that when a first element or layer is referred to as being present "on" or "beneath" a second element or layer, the first element may be disposed directly on or beneath the second element or may be disposed indirectly on or beneath the second element with a third element or layer being disposed between the first and second elements or layers.

It should be noted that if it is described in the specification that one component is "connected" or "coupled" to another component, the first component may be directly connected, coupled, or joined to the second component, or a third component may also be "connected," "coupled," and "joined" between the first and second components.

As used herein, the term "and/or" includes any one and all combinations of one or more of the associated listed items. Additionally, the use of "may" when describing embodiments of the present disclosure relates to "one or more embodiments of the present disclosure."

Expressions such as "one or more" and "at least" preceding a list of elements modify the entire list of elements and do not modify individual elements in the list.

When referring to "A and/or B" throughout the specification, it means A, B, or A and B, unless specifically stated to the contrary. When referring to "C to D", it means that it is greater than or equal to C and less than or equal to D, unless otherwise specified.

When the phrases such as "at least one of A, B, and C," "at least one of A, B, or C," "at least one selected from the group of A, B, and C," and "at least one selected from A, B, and C" are used to specify a list of elements A, B, and C, and the phrases may refer to any suitable combination.

The term "use" may be considered synonymous with the term "utilize."

As used herein, the terms "substantially," "about," and similar terms are used as terms of approximation and are intended to account for inherent variations in the measured or calculated values that would be recognized by a person of ordinary skill in the art.

It will be understood that, although the terms first, second, third, etc., may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "on" or "above" the other elements or features. Thus, the term "below" can encompass both an orientation of above and below.

The terminology used herein is for the purpose of describing particular embodiments only and is not intended to be limiting of the disclosure.

In embodiments of prismatic, pouch-type rechargeable batteries according to embodiments of the present disclosure, one of the prismatic, pouch-type rechargeable batteries is selected and the selected battery is described as having a general structure, and the general structure of the prismatic, pouch-type rechargeable battery is described in the case of generally applied technology.

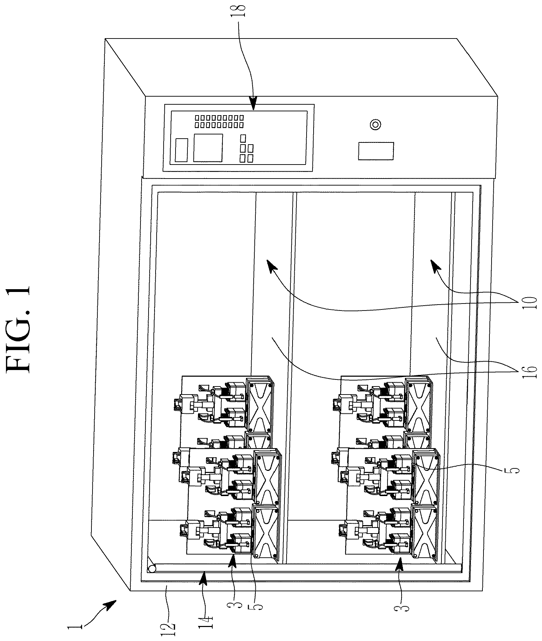

FIG. 1 is a perspective view schematically illustrating a characteristic measuring apparatus configured to measure one or more characteristics of a battery cell for a rechargeable battery (hereinafter referred to as a measuring apparatus for convenience) according to embodiments of the present disclosure.

A measuring apparatus 1 is configured to measure the characteristics of a rechargeable battery through a characteristic measuring jig 3 (hereinafter referred to as a measuring jig for convenience) accommodated in a measuring chamber 10. In one or more embodiments, the measuring jig 3 is configured to measure the impedance of the battery cell.

The measuring chamber 10 may include a plurality of measuring chambers 10 by a frame 14 disposed within the body 12 of the measuring apparatus 1 and a separator 16 connected to the frame 14.

Further, an operation panel 18 is installed on the body 12 of the measuring apparatus 1 for electrical operations such as adjusting the temperature or humidity in the measuring chamber 10 and applying a current to a battery cell 5 to measure the impedance of the battery cell 5 provided in the measuring jig 3.

### First embodiment

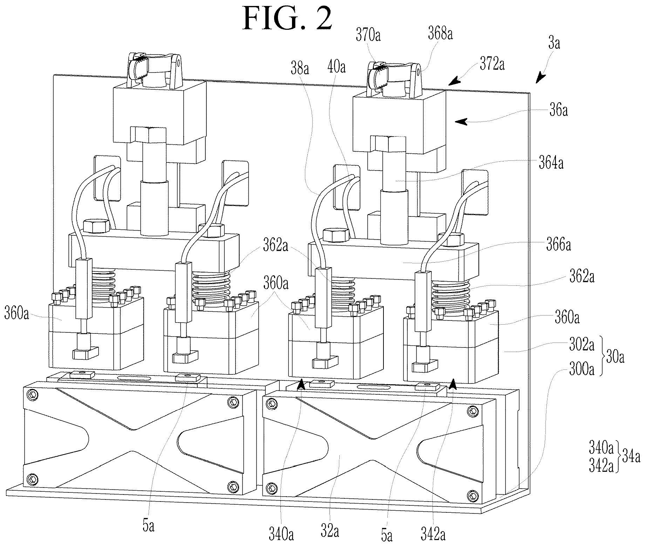

FIG. 2 is a perspective view schematically illustrating a measuring jig 3a according to the first embodiment. As shown in FIG. 2, a measuring jig 3a of the first embodiment includes a support 30a configured to support a battery cell 5a.

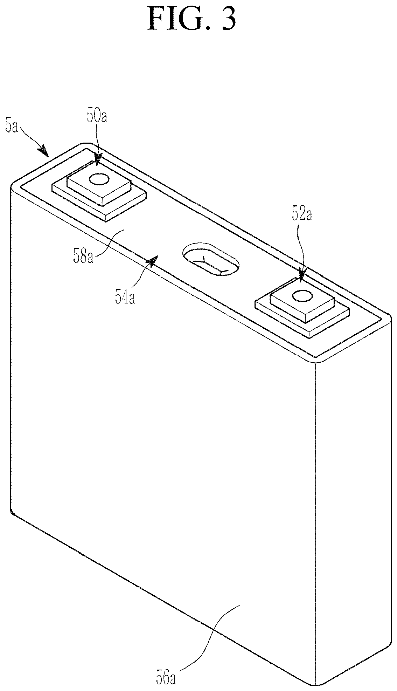

In the first embodiment, the battery cell 5a may be a prismatic battery cell, as shown in FIG. 3. The battery cell 5a has a terminal side 54a and a positive electrode terminal 50a and a negative electrode terminal 52a on the terminal side 54a. The terminal side 54a may refer to a side surface of the prismatic battery cell on which the positive electrode terminal 50a and the negative electrode terminal 52a are arranged. The terminal side 54a may include a side surface of a cap plate 58a that is coupled to a case 56a of the battery cell 5a.

Referring again to FIG. 2, the battery cell 5a may be subjected to an impedance measurement while in a fixing frame 32a fixedly installed on the support 30a. The support 30a includes a bottom plate 300a on which the fixing frame 32a is supported and a vertical plate 302a extending upward from one edge of the bottom plate 300a. The number of fixing frames 32a on the support 30a may vary depending on the number of battery cells 5a. In the first embodiment, one battery cell 5a is provided for each of the two fixing frames 32a, but the structure of the measuring jig 3a is not limited thereto.

An elevating part 36a is fixedly coupled to the vertical plate 302a. The elevating part 36a is configured to elevate an impedance measuring part 34a that is configured to measure the impedance of the battery cell 5a while being detachably attached to the terminal side 54a of the battery cell 5a.

The impedance measuring part 34a includes a positive electrode contact part 340a configured to contact the positive electrode terminal 50a and a negative electrode contact part 342a configured to contact the negative electrode terminal 52a.

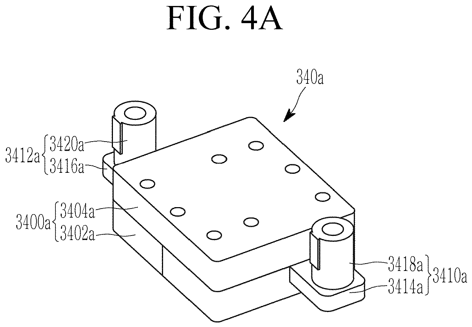

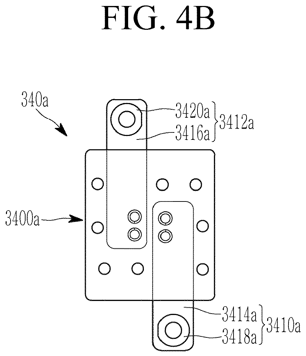

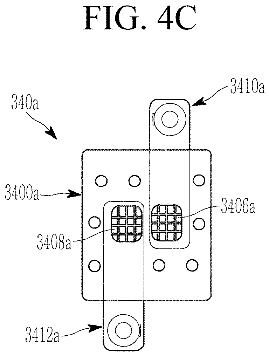

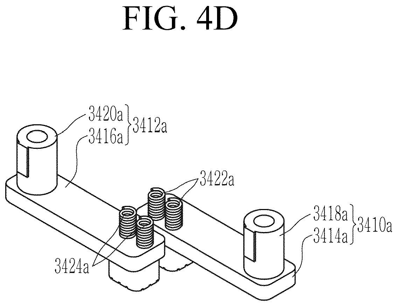

FIGS. 4A to 4D are diagrams to describe the positive electrode contact part 340a. Referring to FIGS. 4A to 4D, the positive electrode contact part 340a includes a first body 3400a having a substantially rectangular parallelepiped shape. The first body 3400a includes a lower body 3402a and an upper body 3404a that can be detachably coupled to each other. First and second positive electrode contact parts 3406a and 3408a are spaced apart at an interval on the lower body 3402a and are configured to contact the positive electrode terminal 50a. The first and second positive electrode contact parts 3406a and 3408a are configured such that their tip parts are exposed outside of the lower body 3402a and are configured to move up and down within the lower body 3402a.

A first terminal for current 3410a and a first terminal for voltage 3412a are connected to the first and second positive electrode contact parts 3406a and 3408a, respectively. The first terminal for current 3410a is connected to the first positive electrode contact part 3406a so that current (alternating current) may be applied to the battery cell 5a. The first terminal for voltage 3412a is connected to the second positive electrode contact part 3408a and is configured to measure the voltage from the battery cell 5a.

In the first embodiment, the first terminal for current 3410a and the first terminal for voltage 3412a each include oppositely arranged, rod-shaped lead parts 3414a and 3416a, respectively, and cylinder-shaped connectors 3418a and 3420a, respectively, connected vertically from one end of the lead parts 3414a and 3416a, respectively.

In the first embodiment, both lead parts 3414a and 3416a are non-collinear and in parallel. The first and second positive electrode contact parts 3406a and 3408a are arranged at approximately the center of the first body 3400a, and the lead parts 3414a and 3416a are arranged on the first body 3400a such that their respective connectors 3418a and 3420a are substantially opposite to each other. In one or more embodiments, the angle between the two lead parts 3414a and 3416a, that is, the angle between the first terminal for current 3410a and the first terminal for voltage 3412a, may be approximately 180°. The arrangement of the first terminal for current 3410a and the first terminal for voltage 3412a is configured to prevent (or at least mitigate) distortion of the impedance to be measured by minimizing the overlapping region between the two terminals 3410a, 3412a and reducing the increase in inductance due to the magnetic field.

In the first embodiment, both lead parts 3414a and 3416a are non-collinear line as described above, but in another embodiment, both lead parts 3414a and 3416a may be arranged on the same line.

Additionally, in the first embodiment, both lead parts 3414a and 3416a are arranged with an angle of approximately 180° as described above, but in one or more embodiments they may be arranged with an angle selected between approximately 90° and approximately 180°.

A current wire 38a for applying current to the first terminal for current 3410a and a voltage wire 40a for sensing voltage of the battery cell 5a from the first terminal for voltage 3412a are connected to the connectors 3418a and 3420a, respectively, as shown in FIG. 2.

A part of both of the lead parts 3414a and 3416a, including the connectors 3418a and 3420a, is exposed outside of the first body 3400a, and the remaining part of both of the lead parts 3414a and 3416a, including the first and second positive electrode contact parts 3406a and 3408a connected to different ends of the lead parts 3414a and 3416a, respectively, is within the first body 3400a.

Referring to FG. 4D, springs 3422a and 3424a are provided on the other ends of the lead parts 3414a and 3416a, respectively, to which the first and second positive electrode contact parts 3406a and 3408a, respectively, are connected opposite the first and second positive electrode contact parts 3406a and 3408a, respectively. The springs 3422a and 3424a are configured to enable the first and second positive electrode contact parts 3406a and 3408a to elastically contact the positive electrode terminal 50a by the force exerted by the elevating part, which will be described later.

In the first embodiment, the area of the first positive electrode contact part 3406a may be equal to or larger than the area of the second positive electrode contact part 3408a, which is to reduce heat generation when actual current flows by reducing the contact resistance of the current terminal.

In one or more embodiments, the negative electrode contact part 342a may have the same configuration as the positive electrode contact part 340a. That is, the negative electrode contact part 342a may also include a second body (lower body/upper body), first and second negative electrode contact parts, a second terminal for current (the lead part/the connector), a second terminal for voltage (the lead part/the connector), and a spring. The detailed description of the negative electrode contact part 342a will be omitted because it is the same as the description of the above-described positive electrode contact part 340a.

The impedance measuring part 34a is connected to the elevating part 36a, which is fixedly coupled to the vertical plate 302a of the support 30a such that the impedance measuring part 34a is configured to move up and down.

As can be seen through FIG. 2, in the first embodiment, the elevating part 36a is configured to elevate the positive electrode contact part 340a and the negative electrode contact part 342a by a hinge or lever method.

The elevating part 36a has a lower pressing part 360a connected to each of the positive electrode contact part 340a and the negative electrode contact part 342a, and a handle part 370a resiliently connected to the lower pressing part 360a. The elevating part 36a also includes a spring 362a on each of the lower pressing parts 360a and between the lower pressing parts 360a and an upper pressing part 366a. The handle part 370a is hingedly coupled to the upper pressing part 366a, which is connected to an elevating shaft 364a, via a hinge pin 368a.

The positive electrode contact part 340a and the negative electrode contact part 342a on the lower pressing part 360a may be connected (e.g., screwed) at an interval, for example, an interval corresponding to the interval between the positive electrode terminal 50a and the negative electrode terminal 52a of the battery cell 5a. The elevating shaft 364a may be guided to a mount holder 372a fixed to the vertical plate 302a.

Accordingly, in response to the user vertically raising the handle part 370a upward from the horizontal state (as shown in Fig. 2) toward the top (or upper) position, the elevating shaft 364a descends, causing the upper pressing part 366a, the lower pressing part 360a, the positive electrode contact part 340a, and the negative electrode contact part 342a to descend in conjunction therewith. As a result, it becomes possible for the first and second positive electrode contact parts 3406a and 3408a to contact the positive electrode terminal 50a of the battery cell 5a, and for the first and second negative electrode contact parts to contact the negative electrode terminal 50b of the battery cell 5a. In this state, the impedance of the battery cell 5a may be measured by allowing current to be applied to the first terminal for current 3410a and the second terminal for current, and sensing the voltage through the first terminal for voltage 3412a and the second terminal for voltage. At this time, the first terminal for current 3410a and the first terminal for voltage 3412a arranged substantially in a straight line so as not to overlap each other (e.g., substantially not overlap each other in a direction perpendicular to a direction in which the first terminal for current 3410a and the first terminal for voltage 3412a extend), and the second terminal for current and the second terminal for voltage are also arranged substantially in a straight line so as not to overlap each other. Therefore, it is possible to reduce the increase in inductance due to the magnetic field, thereby measuring the impedance of the battery cell 5a without distortion (or with minimized or reduced distortion).

Once the measurement of the impedance is completed, the user may lift the handle part 370a from bottom to top (switching from the state shown in FIG. 2 to the vertical state) so that the first and second positive electrode contact parts 3406a and 3408a are separated from the positive electrode terminal 50a of the battery cell 5a, and the first and second negative electrode contact parts are separated from the negative electrode terminal 52a of the battery cell 5a. The battery cell 5a for with the impedance measurement has been completed may then be replaced with a new battery cell that will be measured for impedance.

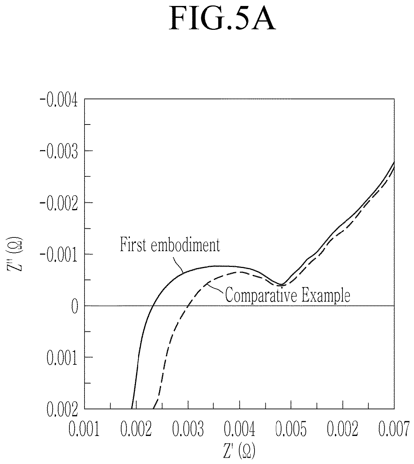

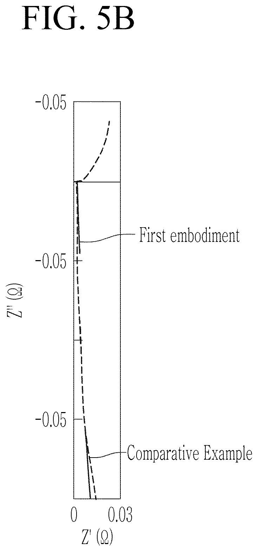

FIGS. 5A and 5B are graphs illustrating the results of measuring charge exchange resistance (Rct) and inductance for the battery cell on a measuring jig 3a according to the first embodiment and a measuring jig according to a Comparative Example, respectively. In the measuring jig according to the Comparative Example, unlike the first embodiment, the first and second terminals for current and the first and second terminals for voltage for the positive electrode terminal and the negative electrode terminal of the battery cell overlap each other and are integrated into one body. The battery cells measured by each measuring jig are prismatic battery cells as shown in FIG. 3.

As can be seen from FIGS. 5A and 5B, when measuring the impedance of a battery cell using the measuring jig 3a of the first embodiment, the improved terminals for current and voltage reduce inductance, thereby allowing impedance to be measured without distortion (or with reduced distortion) of the charge exchange resistance (Rct).

### Second embodiment

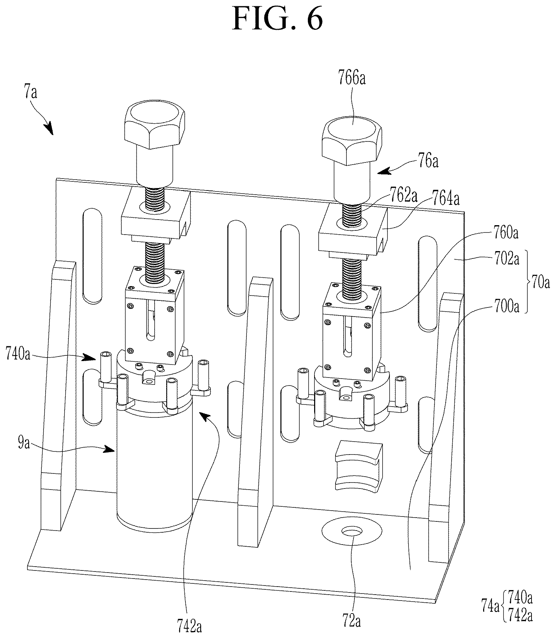

FIG. 6 is a perspective view schematically illustrating a measuring jig 7a according to the second embodiment. As shown in FIG. 6, the measuring jig 7a of the second embodiment includes a support 70a supporting a battery cell 9a.

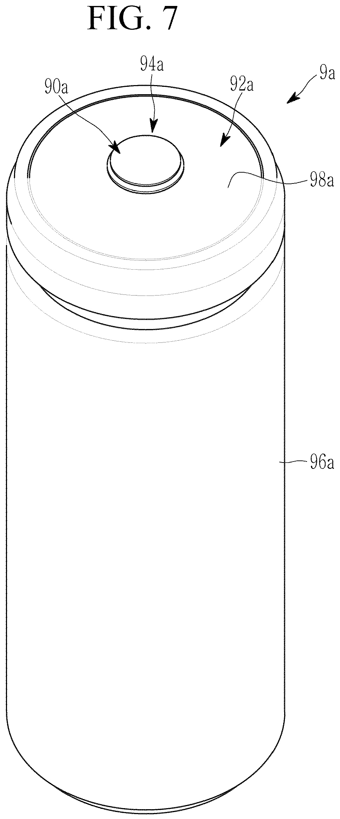

In the second embodiment, the battery cell 9a may be a cylindrical battery cell as shown in FIG. 7. The battery cell 9a has a terminal side 94a including a positive electrode terminal 90a and a negative electrode terminal 92a. The terminal side 94a may refer to the side surface where the positive electrode terminal 90a and the negative electrode terminal 92a are provided in the cylindrical battery cell. The terminal side 94a may include the side surface of the cap plate 98a that is coupled to a case 96a of the battery cell 9a. In one or more embodiments, the positive electrode terminal 90a may have a rivet structure coupled to be electrically separated (insulated) from the cap plate 98a, which is the negative electrode terminal 92a, and the cap plate 98a may be coupled to be electrically connected to the case 96a. Additionally, the positive electrode terminal 90a may be electrically connected to the positive electrode of the electrode assembly accommodated in the case 96a, and the negative electrode terminal 92a may be electrically connected to the negative electrode of the electrode assembly.

Referring again to FIG. 6, the impedance of the battery cell 9a may be measured while placed on the supporting frame 72a, which is fixedly coupled to the support 70a. The support 70a includes a bottom plate 700a on which the supporting frame 72a is arranged and a vertical plate 702a extending upward from one edge of the bottom plate 700a. The number of supporting frames 72a on the support 70a may vary depending on the number of battery cells 9a. In the second embodiment, one battery cell 9a is provided for each of the two supporting frames 72a, but the structure of the measuring jig 7a is not limited thereto.

An elevating part 76a is on the vertical plate 702a. The elevating part 76a is configured to elevate an impedance measurement part 74a, which is configured to measure the impedance of the battery cell 9a while detachably attached to the terminal side 94a of the battery cell 9a.

The impedance measuring part 74a includes a positive electrode contact part 740a in contact with the positive electrode terminal 90a and a negative electrode contact part 742a in contact with the negative electrode terminal 92a.

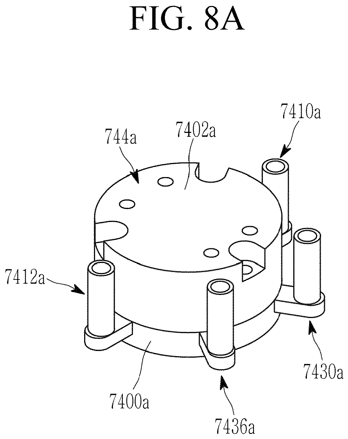

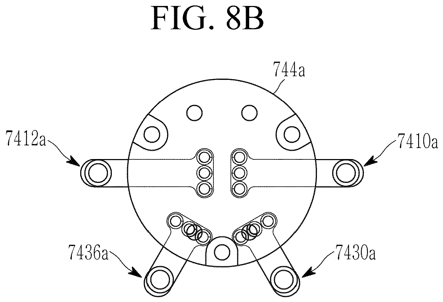

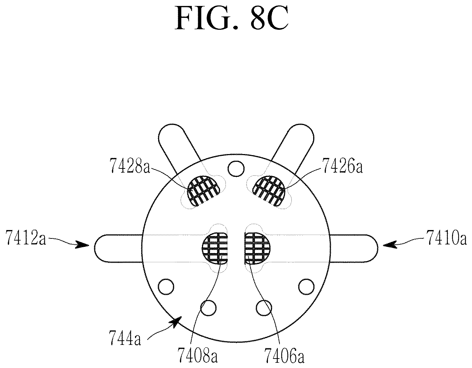

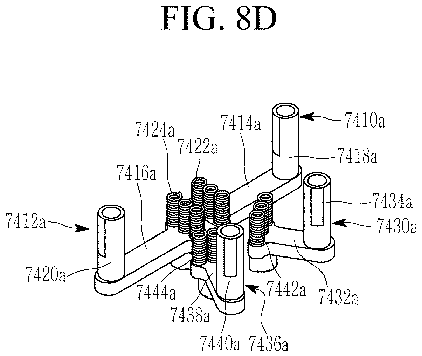

FIGS. 8A to 8D are diagrams to describe the positive electrode contact part 740a and the negative electrode contact part 742a. Referring to FIGS. 8A to 8D, the impedance measuring part 74a includes a single body 744a having a substantially cylindrical shape. The single body 744a includes a lower body 7400a and an upper body 7402a that are configured to be detachably coupled to each other. On the lower body 7400a, first and second positive electrode contact parts 7406a and 7408a, respectively, in contact with the positive electrode terminal 90a, are installed at an interval. The first and second positive electrode contact parts 7406a and 7408a are configured such that their tip parts are exposed outside of the lower body 7400a and may move up and down within the lower body 7400a.

A first terminal for current 7410a and a first terminal for voltage 7412a are connected to the first and second positive electrode contact parts 7406a and 7408a, respectively. The first terminal for current 7410a is connected to the first positive electrode contact part 7406a so that current (alternating current) may be applied to the battery cell 9a. Additionally, the first terminal for voltage 7412a is connected to the second positive electrode contact part 7408a and is configured to measure the voltage from the battery cell 9a.

In the second embodiment, the first terminal for current 7410a and the first terminal for voltage 7412a each include oppositely arranged, rod-shaped lead parts 7414a and 7416a, respectively, and cylinder-shaped connectors 7418a and 7420a, respectively, connected vertically from one end of the lead parts 7414a and 7416a, respectively.

In the second embodiment, both lead parts 7414a and 7416a are collinear and in parallel (or substantially collinear and in parallel). The first and second positive electrode contact parts 7406a and 7408a are at approximately the center of the single body 744a, and both lead parts 7414a and 7416a are arranged on the single body 744a such that their respective connectors 7418a and 7420a are oppositely arranged. Accordingly, the angle between both lead parts 7414a and 7416a, that is, the angle between the first terminal for current 7410a and the first terminal for voltage 7412a, is approximately 180°. The arrangement of the first terminal for current 7410a and the first terminal for voltage 7412a is configured to prevent (or at least mitigate) distortion of the impedance to be measured by minimizing (or at least reducing) the overlapping region between the terminals 7410a, 7412a and thereby reducing the increase in inductance due to the magnetic field.

In the second embodiment, both lead parts 7414a and 7416a are arranged collinear as described above, but in another embodiment, both lead parts 7414a and 7416a may be non-collinear.

Additionally, in the second embodiment, the lead parts 7414a and 7416a are arranged with an angle of approximately 180° as described above, but in one or more embodiments may be arranged with an angle selected between approximately 90° and approximately 180°.

A current wire configured to apply current to the first terminal for current 7410a and a voltage wire configured to sense voltage of the battery cell 9a from the first terminal for voltage 7412a are connected to the connectors 7418a and 7420a, respectively.

A part of each of the lead parts 7414a and 7416a, including the connectors 7418a and 7420a, is exposed outside of the single body 744a, and the remaining part of each of the lead parts 7414a and 7416a, including the first and second positive electrode contact parts 7406a and 7408a connected to different ends of the lead parts 7414a and 7416a, is within the first lower body 7400a.

Springs 7422a and 7424a are on the other ends of the lead parts 7414a and 7416a, respectively, to which the first and second positive electrode contact parts 7406a and 7408a, respectively, are connected opposite the first and second positive electrode contact parts 7406a and 7408a, respectively. The springs 7422a and 7424a are configured to enable the first and second positive electrode contact parts 7406a and 7408a to elastically contact the positive electrode terminal 90a by the force exerted by the elevating part, which will be described later.

In the second embodiment, the area of the first positive electrode contact part 7406a may be equal to or larger than the area of the second positive electrode contact part 7408a, which is to reduce heat generation when actual current flows by reducing the contact resistance of the current terminal.

The negative electrode contact part 742a has the same configuration as the positive electrode contact part 740a. That is, the negative electrode contact part 742a also includes first and second negative electrode contact parts 7426a and 7428a, a second terminal for current 7430a (a lead part 7432a/a connector 7434a), a second terminal for voltage 7436a (a lead part 7438a/a connector 7440a), and springs 7442a and 7444a. The detailed description of the negative electrode contact part 742a will be omitted because it has the same configuration as the above-described positive electrode contact part 740a.

However, the negative electrode contact part 742a is installed on the single body 744a together with the positive electrode contact part 740a, but is arranged such that the second terminal for current 7430a and the second terminal for voltage 7436a are disposed between the first terminal for current 7410a and the first terminal for voltage 7412a, and the angle therebetween forms an acute angle (e.g., approximately 10° to approximately 80°).

The impedance measuring part 74a is connected to the elevating part 76a, which is fixedly installed to the vertical plate 702a of the support 70a such that the impedance measuring part 74a may move up and down.

As can be seen through FIG. 6, in the second embodiment, the elevating part 76a is configured to elevate the positive electrode contact part 740a and the negative electrode contact part 742a by a screw method.

The elevating part 76a includes a pressing part 760a connected (e.g., screwed) to each of the positive electrode contact part 740a and the negative electrode contact part 742a, an elevating shaft 762a that is connected to the pressing part 760a and provided with threads, a mount holder 764a fixed to the vertical plate 702a and coupled to the elevating shaft 762a such that the elevating shaft 762a may be elevated and guided in a screwed manner, and a handle part 766a that is coupled to one end (e.g., an upper end) of the elevating shaft 762a.

Accordingly, in response to the user rotating the handle part 766a clockwise, the elevating shaft 762a descends and the pressing part 760a, the positive electrode contact part 740a, and the negative electrode contact part 742a also descend in conjunction therewith. As a result, it becomes possible for the first and second positive electrode contact parts 7406a and 7408a to contact the positive electrode terminal 90a of the battery cell 9a, and for the first and second negative electrode contact parts 7426a and 7428a to contact the negative electrode terminal 92a of the battery cell 9a. In this state, the impedance of the battery cell 9a may be measured by allowing current to be applied to the first terminal for current 7410a and the second terminal for current 7430a, and sensing the voltage through the first terminal for voltage 7412a and the second terminal for voltage 7436a. The first terminal for current 7410a and the first terminal for voltage 7412a are arranged substantially in a straight line so as not to overlap each other, and the second terminal for current 7430a and the second terminal for voltage 7436a are also arranged so as not to overlap each other. Therefore, it is possible to reduce the increase in inductance due to the magnetic field, thereby measuring the impedance of the battery cell 9a without distortion (or with minimal or at least reduced distortion).

Once the measurement of the impedance is completed, the user may rotate the handle part 766a counterclockwise so that the first and second positive electrode contact parts 7406a and 7408a are separated from the positive electrode terminal 90a of the battery cell 9a, and the first and second negative electrode contact parts 7426a and 7428a are separated from the negative electrode terminal 92a of the battery cell 9a. The battery cell for which the impedance measurement has been completed may then be replaced with a new battery cell that will be measured for impedance.

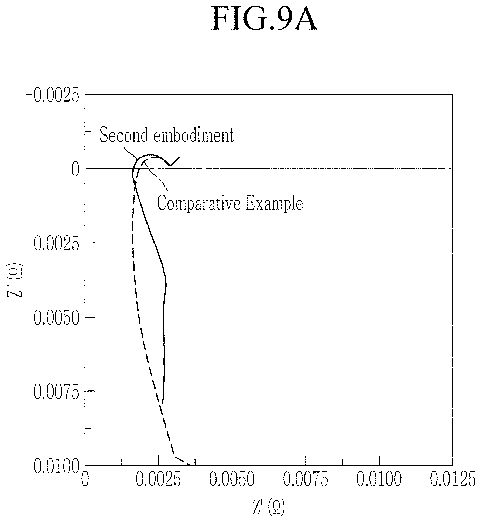

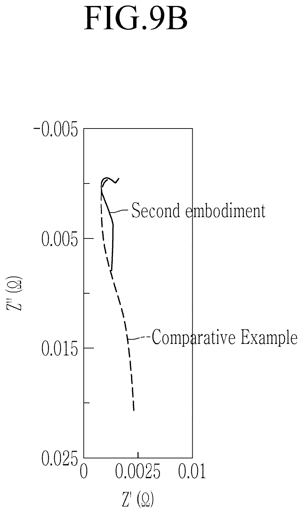

FIGS. 9A and 9B are graphs illustrating the results of measuring charge exchange resistance (Rct) and inductance for the battery cell on a measuring jig according to the second embodiment and a measuring jig according to Comparative Example, respectively. In the measuring jig according to the Comparative Example, unlike the second embodiment, the first and second terminals for current and the first and second terminals for voltage for the positive electrode terminal and the negative electrode terminal of the battery cell overlap each other and are integrated into one body. The battery cells measured by each measuring jig are cylindrical battery cells as shown in FIG. 7.

As can be seen from FIGS. 9A and 9B, when measuring the impedance of a battery cell using the measuring jig 7a of the second embodiment, the improved terminals for current and voltage reduce inductance, allowing impedance to be measured without distortion (or with reduced distortion of) the charge exchange resistance (Rct).

While the embodiments of the present disclosure have been described in detail, it is to be understood that the disclosure is not limited to the disclosed embodiments, but on the contrary, is intended to cover various modifications and equivalent arrangements included within the scope of the appended claims.

### Reference signs

3a,7a: Measuring jig
5a,9a: Battery cell
30a,70a: Support
3406a,7406a: First positive electrode contact part
3408a,7408a: Second positive electrode contact part
7426a: First negative electrode contact part
7428a: Second negative electrode contact part
3410a,7410a: First terminal for current
7430a: Second terminal for current
3412a,7412a: First terminal for voltage
7436a: Second terminal for voltage
34a,74a: Impedance measuring part
36a,76a: Elevating part

## Claims

1. A characteristic measuring jig (3, 3a, 7a) configured to measure one or more characteristics of a battery cell (5a, 9a) for a rechargeable battery, the characteristic measuring jig (3, 3a, 7a) comprising:
a support (30a, 70a) configured to support the battery cell (5a, 9a), the battery cell (5a, 9a) comprising a terminal side (54a) comprising a positive electrode terminal (50a) and a negative electrode terminal (52a);
an impedance measuring part (34a, 74a) detachable from the terminal side (54a) of the battery cell (5a, 9a), the impedance measuring part (34a, 74a) comprising:
first and second positive electrode contact parts (3406a, 7406a, 3408a 7408a) configured to contact the positive electrode terminal (50a);
first and second negative electrode contact parts (7426a, 7428a) configured to contact the negative electrode terminal (52a);
a first terminal for current (3410a, 7410a) connected to the first positive electrode contact part (3406a) and configured to apply current to the battery cell (5a, 9a);
a first terminal for voltage (3412a, 7412a) connected to the second positive electrode contact part (3406a) and configured to measure voltage of the battery cell (5a, 9a);
a second terminal for current (7430a) connected to the first negative electrode contact part (7426a) and configured to apply current to the battery cell (5a, 9a); and
a second terminal for voltage (7436a) connected to the second negative electrode contact part (7428a) and configured to measure voltage of the battery cell (5a, 9a); and
an elevating part (36a, 76a) fixed to the support (30a, 70a), connected to the impedance measuring part (34a, 74a), and configured to elevate the impedance measuring part (34a, 74a) with respect to the terminal side (54a) of the battery cell (5a, 9a),
wherein at least one of the first terminal for current (3410a, 7410a) and the second terminal for current (7430a) is substantially opposite to at least one of the first terminal for voltage (3412a, 7412a) and the second terminal for voltage (7436a).

2. The characteristic measuring jig (3, 3a, 7a) as claimed in claim 1, wherein the impedance measuring part (34a, 74a) comprises:
a first body (3400a) to which the first and second positive electrode contact parts (3406a, 7406a, 3408a 7408a), the first terminal for current (3410a, 7410a), and the first terminal for voltage (3412a, 7412a) are coupled, and
a second body to which the first and second negative electrode contact parts (7426a, 7428a), the second terminal for current (7430a), and the second terminal for voltage (7436a) are coupled, spaced apart from the first body (3400a) and adjacent to the first body (3400a).

3. The characteristic measuring jig (3, 3a, 7a) as claimed in claim 1 or 2, wherein the first terminal for current (3410a, 7410a) and the first terminal for voltage (3412a, 7412a) are non-overlapping on a same line in the first body (3400a).

4. The characteristic measuring jig (3, 3a, 7a) as claimed in any one of claims 1 to 3, wherein the second terminal for current (7430a) and the Second terminal for voltage (7436a) are non-overlapping on a same line in the second body.

5. The characteristic measuring jig (3, 3a, 7a) as claimed in any one of claims 1 to 4, wherein an area of the first positive electrode contact part (3406a) is equal to or greater than an area of the second positive electrode contact part (3406a).

6. The characteristic measuring jig (3, 3a, 7a) as claimed in any one of claims 1 to 5, wherein an area of the first negative electrode contact part (7426a) is equal to or greater than an area of the second negative electrode contact part (7428a).

7. The characteristic measuring jig (3, 3a, 7a) as claimed in any one of claims 1 to 6, wherein the impedance measuring part (34a, 74a) comprises:
a single body (744a) to which the first and second positive electrode contact parts (3406a, 7406a, 3408a 7408a), the first terminal for current (3410a, 7410a), the first terminal for voltage (3412a, 7412a), the first and second negative electrode contact parts (7426a, 7428a), the second terminal for current (7430a), and the Second terminal for voltage (7436a) are coupled.

8. The characteristic measuring jig (3, 3a, 7a) as claimed in any one of claims 1 to 7, wherein the first terminal for current (3410a, 7410a) and the first terminal for voltage (3412a, 7412a) are non-overlapping on a same line in the single body (744a).

9. The characteristic measuring jig (3, 3a, 7a) as claimed in any one of claims 1 to 8, wherein the second terminal for current (7430a) and the Second terminal for voltage (7436a) are between the first terminal for current (3410a, 7410a) and the first terminal for voltage (3412a, 7412a), and an angle between the second terminal for current (7430a) and the Second terminal for voltage (7436a) is an acute angle.

10. The characteristic measuring jig (3, 3a, 7a) claimed in any one of claims 1 to 9, wherein an area of the first positive electrode contact part (3406a) and an area of the first negative electrode contact part (7426a) are equal to or greater than an area of the second positive electrode contact part (3406a) and an area of the second negative electrode contact part (7428a), respectively.

11. The characteristic measuring jig (3, 3a, 7a) claimed in any one of claims 1 to 10, further comprising a fixing frame (32a) on the support (30a, 70a), the fixing frame (32a) being configured to fix the battery cell (5a, 9a) on the support (30a, 70a), wherein the support (30a, 70a) preferably comprises a bottom plate (700a) and a vertical plate (702a) extending from one side of the bottom plate (700a), the fixing frame (32a) being on the bottom plate (700a).

12. The characteristic measuring jig (3, 3a, 7a) as claimed in any one of claims 1 to 11, wherein the battery cell (5a, 9a) has a prismatic shape, or wherein the battery cell (5a, 9a) has a cylindrical shape.

13. The characteristic measuring jig (3, 3a, 7a) as claimed in any one of claims 1 to 12, further comprising a supporting frame (72a) on the support (30a, 70a), the support frame (72a) being configured to support the battery cell (5a, 9a).

14. The characteristic measuring jig (3, 3a, 7a) as claimed in any one of claims 1 to 13, wherein the support (30a, 70a) comprises a bottom plate (700a) and a vertical plate (702a) extending from one side of the bottom plate (700a), the supporting frame (72a) being on the bottom plate (700a).

15. A characteristic measuring apparatus (1) configured to measure a characteristic of a battery cell (5a, 9a) for a rechargeable battery, the characteristic measuring apparatus comprising (1):
a housing accommodating the characteristic measuring jig (3, 3a, 7a) as claimed in any one of claims 1 to 14, the housing comprising a chamber (10), a current wire (38a) configured to apply current to the first terminal for current (3410a, 7410a) and the second terminal for current (7430a), and a voltage wire (40a) configured to sense voltage of the battery cell (5a, 9a) from the first terminal for voltage (3412a, 7412a) and the Second terminal for voltage (7436a).
